# EUROPEAN PATENT APPLICATION

(11) **EP 2 362 504 A1**
(43) Date of publication of application: **31.08.2011**
(21) Application number: 10305170.2
(22) Date of filing: 19.02.2010
(51) Int. Cl.: H01S 5/0625, H01S 5/10, H01S 5/40, H01S 5/065, H03B 28/00

(54) **A laser device**

(71) Applicant: Alcatel Lucent, 75008 Paris (FR)
(72) Inventor: Van Dijk, Frederic, 91460 Marcoussis (FR); Debregeas-Sillard, Hélène, 78150 Le Chesnay (FR)
(74) Representative: Shamsaei Far, Hassan

(57) **Abstract**

A laser device (D) comprises i) an active lasing medium (AM) arranged for generating photons of different optical frequencies, ii) at least two single periodicity reflecting means (RM1-RM2) each arranged for reflecting selectively, toward an input/output, photons having an optical frequency chosen amongst these different optical frequencies, and iii) an optical coupling means (CM), comprising a first input/output connected to an input/output of the active lasing medium (AM) and at least two other second inputs/outputs coupled to its first input/output and connected respectively to the inputs/outputs of the single periodicity reflecting means (RM1-RM2), and arranged for coupling simultaneously these single periodicity reflecting means (RM1-RM2) with this active lasing medium (AM), such that the latter (AM) outputs simultaneously photons having the chosen optical frequencies.

## Description

The present invention relates to laser devices.

By the terms "laser device" it is intended to refer to a device which comprises at least one laser (or active lasing medium) coupled to one or more other optical means and/or optoelectronic means.

### BACKGROUND ART

As it is known by a person skilled in the art, some laser devices are conceived for producing an electrical beating signal having a chosen beating frequency from first and second photons having respectively first and second optical frequencies. The chosen beating frequency is generally equal to the difference between the first and second optical frequencies.

### SUMMARY

Several solutions have been proposed for producing the first and second photons.

A first solution consists in using two separate laser sources coupled through a Y coupler or a Multimode Interference (or MMI) coupler, and then in using a photodiode for producing an electrical beating signal by means of a heterodyne detection of the first and second photons. However, when the electrical beating signal must be produced with a reduced width, typically it becomes necessary to add a short phase locking loop on each laser source to stabilize the first and second optical frequencies of the photons they produce respectively. So this first solution becomes complex. Moreover, the width reduction of the electrical beating signal appears to be all the more limited by the width of the optical signals in the optical frequency domain of the first and second photons as the first and second optical frequencies are decorrelated.

A second solution consists in putting in series two Bragg filters, having different strengths and capable of selecting different optical frequencies, into an optical cavity. However, typically it is difficult in this case to control the respective powers of the first and second optical signals because the strengths of the Bragg filters, and therefore their reflectivities, are different.

A third solution consists in coupling longitudinally two Distributed FeedBack (DFB) lasers into the same active waveguide. However, typically the active lasing media of the two DFB lasers are not the same. So, the two lasing optical frequencies are not correlated which induces increased width of the generated beating signal. Moreover, as the light (photons) produced by one of the DFB lasers typically has to go through the other DFB laser, its optical power is impaired and therefore it is very difficult to get equilibrium between the optical powers generated by the two DFB lasers.

Embodiments of the invention aim at proposing a new laser device capable of producing photons simultaneously with the same gain medium and having at least two different optical frequencies, notably and not exclusively for allowing generation of an electrical beating signal having an electrical ray with a reduced width.

This new laser device comprises:
- an active lasing medium arranged for generating photons of different optical frequencies,
- at least two single periodicity reflecting means, each arranged for reflecting selectively, toward an input/output, photons having an optical frequency chosen amongst said different optical frequencies, and
- an optical coupling means, comprising a first input/output connected to a first input/output of the active lasing medium and at least two other second inputs/outputs coupled to the first input/output and connected respectively to the inputs/outputs of the single periodicity reflecting means, and arranged for coupling simultaneously the single periodicity reflecting means with the active lasing medium, such that the active lasing medium outputs simultaneously photons having said chosen optical frequencies.

The laser device according to the invention may include additional characteristics considered separately or combined, and notably:
- each single periodicity reflecting means may comprise a single periodicity reflector, arranged for reflecting photons having a chosen optical frequency, and a phase tuning means (or section, for instance) arranged for slightly modifying the phase of photons reflected by the single periodicity reflecting means;
   ➢ each single periodicity reflector may be a distributed Bragg reflector (or DBR) or a dielectric mirror or else any slightly tunable optical frequency selective mirror;
- the optical coupling means may comprise a Multimode Interference (or MMI) coupler, or a Y coupler, or a free-space coupler;
- the optical coupling means and/or the single periodicity reflectors and/or the phase tuning means may be made of a passive semiconductor material; ➢ the passive semiconductor material may be GalnAsP (Gallium Indium Arsenium Phosphide);
- in a variant the optical coupling means and/or the phase tuning means may be made of an active semiconductor material;
   ➢ the active semiconductor material may be GalnAsP;
- the active lasing medium may be made of an active semiconductor material;
   ➢ the active lasing medium may comprise multiple quantum wells;
   ➢ the active lasing medium may be made of GalnAsP;
- the laser device may comprise a photodiode arranged for producing an electrical signal having a frequency equal to the difference between the two chosen optical frequencies, from the photons having these two chosen optical frequencies.

The terms "input/output" is to be understood to refer to a port capable of transmitting a signal (an output signal) and receiving a signal (an input signal).

### BRIEF DESCRITPION OF THE DRAWINGS

Other features and advantages of the invention will become apparent on examining the following detailed description as well as the claims and the appended drawings, wherein:
- figure 1 schematically illustrates a first example of a laser device according to a first embodiment of the invention intended for producing simultaneously photons having two chosen optical frequencies, and
- figure 2 schematically illustrates a second example of a laser device according to a second embodiment of the invention intended for producing simultaneously photons having three chosen optical frequencies.

### DETAILED DESCRIPTION

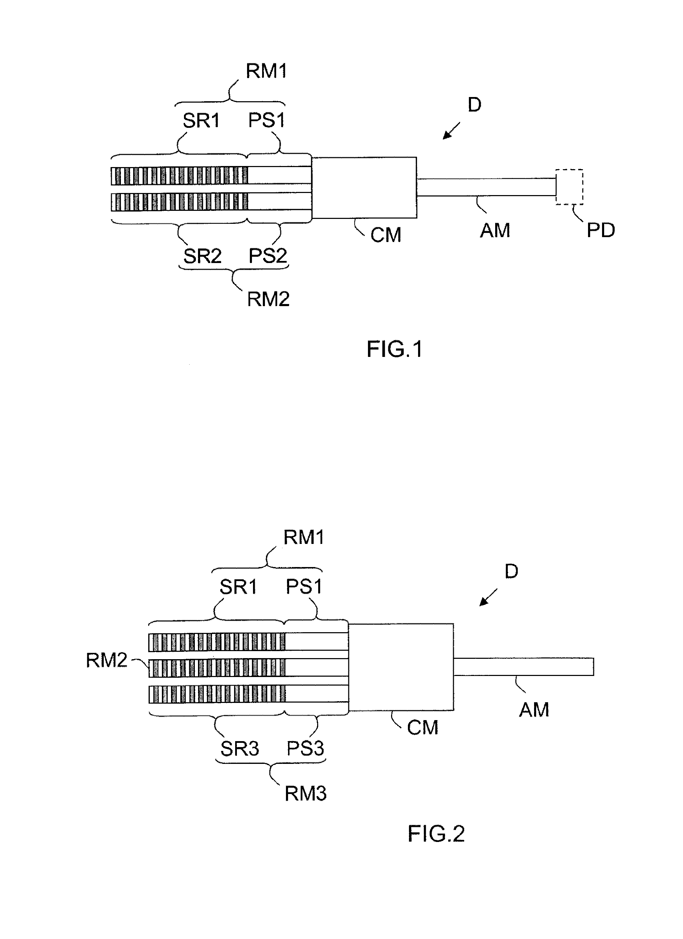

As it is schematically illustrated in figure 1, a laser device D according to embodiments of the invention comprises at least an active lasing medium AM, two or more single periodicity reflecting means RMi and an optical coupling means CM.

It is important to note that such a laser device D may be fully integrated, *i.e.* made on a single substrate, for instance by epitaxy.

The active lasing medium AM is preferably an active cavity that is arranged for generating photons of different optical frequencies by stimulated emission.

The active cavity AM may be defined by multiple quantum wells (or MQWs), or bulk material, or quantum dots, for instance.

Moreover, the active cavity AM may be made of an active semiconductor material, such as GalnAsP, for instance.

Furthermore, the active cavity AM comprises an input/output which is connected to a first input/output of the optical coupling means CM, and an output, which is preferably at an opposite side with respect to the first input/output.

As illustrated in the non limitative example of figure 1, the active cavity output may be coupled to a photodiode PD the function of which will be described below. When this active cavity output is directly connected to the photodiode PD, the latter (PD) is part of the laser device D, as illustrated in the non limitative example of figure 1. But this is not mandatory. Indeed, the active cavity output could be coupled to a photodiode PD (or another element or equipment) through a waveguide or an optical fibre.

Each single periodicity reflecting means RMi preferably comprises a single input/output which is connected to a corresponding second input/output of the optical coupling means CM which is coupled to the active cavity AM through its first input/output.

In the non limitative example illustrated in figure 1, the laser device D comprises two single periodicity reflecting means RMi (i = 1 or 2). But, the laser device D may comprise more than two single periodicity reflecting means RMi, and for instance three (i = 1 to 3) as illustrated in the non limitative example of figure 2, or even more.

Each single periodicity reflecting means RMi may receive photons, originating from the active lasing medium AM via the optical coupling means CM, onto its input/output, and is arranged for selectively reflecting, toward its input/output, photons having an optical frequency which is chosen amongst the different optical frequencies of the photons generated by the active lasing medium AM.

As illustrated in the non limitative examples of figures 1 and 2, each single periodicity reflecting means RMi may comprise a single periodicity reflector SRi and a phase tuning means (or section) PSi which comprises an input/output connected to a corresponding second input/output of the optical coupling means CM and an input/output connected to the unique input/output of the associated single periodicity reflector SRi. The phase tuning means PSi can be, for instance, a phase tuning section.

Each single periodicity reflector SRi is preferably arranged for reflecting selectively photons, provided by the optical coupling means CM and having a chosen optical frequency, onto its unique input/output (to feed the associated phase tuning section (or more generally means) PSi). So, it proceeds to a first (coarse) optical frequency selection.

Each single periodicity reflector SRi is preferably a distributed Bragg reflector (or DBR) whose Bragg grating has a single and unique periodicity which is chosen (computed) for selecting a chosen optical frequency. Alternatively, the single periodicity reflector may be a dielectric mirror, or an external rotating mirror, or more generally a slightly tuneable optical frequency selective mirror.

Each phase tuning section PSi is arranged for letting photons, reflected by its associated single periodicity reflector SRi, pass toward its input/output which is connected to the optical coupling means CM, when they have a chosen optical frequency. The phase change produced by the single periodicity reflectors SRi can be finely tuned by the phase tuning section SMi to more precisely define the optical frequency difference between modes reflected by both single periodicity reflectors SRi, thereby more precisely defining the optical output beating frequency. The optical frequencies fine tuning can be achieved by thermal tuning (with local heaters or current injection, for instance), or by mechanical tuning (with micro-electromechanical systems (or MEMS), for instance), or by carrier density variation (with current injection, for instance).

It is important to note that a phase tuning section PSi and its associated single periodicity reflector SRi may be defined into the same waveguide. But this is not mandatory.

Each single periodicity reflector SRi may be made of a passive semiconductor material. For instance, this passive semiconductor material may be a quaternary material such as GalnAsP (Gallium Indium Arsenium Phosphide).

Each phase tuning section PSi may be made of a passive semiconductor material. For instance, this passive semiconductor material may be a quaternary material such as GalnAsP (Gallium Indium Arsenium Phosphide).

An additional amplification may be further provided by means of an active material located between the phase tuning section PSi and the optical coupling means CM, in order to compensate (at least partially) for losses. This additional active material can be made with the same material as the material of the active lasing medium AM.

The optical coupling means CM preferably comprises as many second inputs/outputs as single periodicity reflecting means RMi. It is arranged for coupling simultaneously (optically) these single periodicity reflecting means RMi with the active lasing medium AM such that the latter AM emits simultaneously photons with the chosen optical frequencies defined by the different single periodicity reflecting means RMi, onto its output (which is possibly coupled to a photodiode PD).

For instance, the optical coupling means CM may comprise (or may be) a Multimode Interference (or MMI) coupler. But in a variant it could be a Y coupler or a free-space coupler, for instance.

Moreover, the optical coupling means CM may be made of a passive semiconductor material. For instance, this passive semiconductor material may be a quaternary material such as GalnAsP. But in a variant the optical coupling means CM may be made of an active semiconductor material, such as InGaAsP, for instance, to compensate (at least partially) for losses.

Because of the simultaneous coupling of the single periodicity reflecting means RMi with a single and common active lasing medium AM through the optical coupling means CM, the laser device D constitutes a kind of laser with several selective reflectors which is capable of generating simultaneously photons having several chosen optical frequencies by stimulated emission. The use of a single and common active lasing medium AM for these different chosen optical frequencies allows to get a strong correlation between these different chosen optical frequencies and therefore an important reduction of the width of the corresponding beating frequency. Indeed, these different chosen optical frequencies may undergo the same refractive index variations, induced by the fluctuations of the carrier density resulting from the noise and the parasitic interferences, during their amplification in the single and common active lasing medium AM. Moreover, the use of a single and common active lasing medium AM may allow simultaneous intra-cavity stimulation for the different chosen optical frequencies and therefore the possible use of a simpler and potentially more efficient scheme of signal injection or re-injection to further decrease the width of the electrical beating signal. The injected or re-injected signal can be provided through an optical means or by an electrical means, or by simultaneously an electrical means and an optical means. For the second option, the bias current of the common active lasing medium AM is modulated with the injected or re-injected signal. For instance it is possible to use a mutual locking by modulation side bands.

Thanks to the embodiments of the invention, the difference in power between the different chosen optical frequencies remains very low. This is of importance in case where the photons having two different chosen optical frequencies feed a photodiode PD such that the latter (PD) produces an electrical signal having a chosen frequency (for instance in the microwave domain) by means of a heterodyne detection. Indeed, this allows to get a good conversion efficiency between the input optical power and the output electrical power that is obtained by means of the heterodyne beat detection.

Moreover, when the laser device D is arranged for producing simultaneously photons having more than two different chosen optical frequencies, this allows a mutual locking of the selected optical modes due to the non linear effects into the single and common active lasing medium AM. This promotes reduction of the width of the electrical signal that may be produced by a photodiode PD because the random variations of the optical phase are strongly correlated.

The invention is not limited to the embodiments of laser device described above, only as examples, but it encompasses all alternative embodiments which may be considered by one skilled in the art within the scope of the claims hereafter.

## Claims

1. Laser device (D), comprising i) an active lasing medium (AM) arranged for generating photons of different optical frequencies, ii) at least two single periodicity reflecting means (RMi) each arranged for selectively reflecting, toward an input/output, photons having an optical frequency comprised amongst said different optical frequencies, and iii) an optical coupling means (CM), comprising a first input/output connected to an input/output of said active lasing medium (AM) and at least two other second inputs/outputs coupled to said first input/output and connected respectively to said inputs/outputs of said single periodicity reflecting means (RMi), and arranged for coupling simultaneously said single periodicity reflecting means (RMi) with said active lasing medium (AM), such that the active lasing medium (AM) outputs simultaneously photons having said chosen optical frequencies.

2. Laser device according to claim 1, wherein each single periodicity reflecting means (RMi) comprises a single periodicity reflector (SRi) arranged for reflecting photons having a chosen optical frequency and a phase tuning means (PSi) arranged for slightly modifying the phase of photons that have been reflected by said single periodicity reflector (SRi).

3. Laser device according to claim 2, wherein each single periodicity reflector (SRi) can be chosen from a group comprising at least a distributed Bragg reflector, a dielectric mirror and a slightly tunable optical frequency selective mirror.

4. Laser device according to one of claims 1 to 3, wherein said optical coupling means (CM) can be chosen from a group comprising at least a Multimode Interference coupler, a Y coupler and a free-space coupler.

5. Laser device according to one of claims 1 to 4, wherein said optical coupling means (CM) and/or said single periodicity reflector (SRi) and/or said phase tuning means (PSi) is/are made of a passive semiconductor material.

6. Laser device according to claim 5, wherein said passive semiconductor material is GalnAsP.

7. Laser device according to one of claims 1 to 5, wherein said optical coupling means (CM) and/or said phase tuning means (PSi) is/are made of an active semiconductor material.

8. Laser device according to claim 7, wherein said active semiconductor material is GalnAsP.

9. Laser device according to one of claims 1 to 8, wherein said active lasing medium (AM) is made of an active semiconductor material.

10. Laser device according to claim 9, wherein said active lasing medium (AM) comprises multiple quantum wells.

11. Laser device according to one of claims 9 and 10, wherein said active lasing medium (AM) is made of GalnAsP.

12. Laser device according to one of claims 1 to 11, comprising a photodiode (PD) arranged for producing an electrical signal having a frequency equal to the difference between said two chosen optical frequencies, from said photons having said two chosen optical frequencies, output by said active lasing medium (AM).
